# EUROPEAN PATENT SPECIFICATION

(11) **EP 2 429 076 B1**
(45) Date of publication and mention of the grant of the patent: **21.08.2013**
(21) Application number: 11167052.7
(22) Date of filing: 23.05.2011
(51) Int. Cl.: H03H 11/04, H03H 11/12

(54) **Filter adjusting apparatus, power adjusting system, and filter adjusting method**
Filtereinstellvorrichtung, Stromeinstellsystem und Filtereinstellverfahren
Appareil de réglage de filtre, système de réglage de la puissance et procédé de réglage de filtre

(30) Priority: 19.08.2010 JP 2010184223
(43) Date of publication of application: 14.03.2012
(73) Proprietor: Kabushiki Kaisha Toshiba, Tokyo 105-8001 (JP)
(72) Inventor: Iwata, Shigeyasu, Tokyo (JP); Ishihara, Hiroaki, Tokyo (JP); Kogawa, Tsuyoshi, Tokyo (JP); Otaka, Shoji, Tokyo (JP)
(74) Representative: Henkel, Breuer & Partner

(56) References cited:
- US-A1- 2005 156 661
- US-A1- 2007 229 152
- VAN BEZOOIJEN A ET AL: "Adaptive Impedance-Matching Techniques for Controlling L Networks", IEEE TRANSACTIONS ON CIRCUITS AND SYSTEMS I: REGULAR PAPERS, IEEE, US, vol. 57, no. 2, 1 February 2010 (2010-02-01), pages 495-505, XP011333613, ISSN: 1549-8328, DOI: 10.1109/TCSI.2009.2023764

## Description

Embodiments described herein relate generally to a filter adjusting apparatus, power adjusting system, and a filter adjusting method, which can automatically adjust filter characteristics.

Filter circuits are used in various fields such as a radio communication field. Many filter circuits used in the radio communication field extract a desired frequency component from a received signal. Receivers which comprise such a filter circuit used in the radio communication field are desirably used in the form of an integrated circuit to generally suppress the cost and power consumption. Therefore, it is necessary to mount also the filter circuit onto an integrated circuit. In addition, in many filter circuits such as RC passive filters and RC active filters, the filter characteristic is determined by element values of resistive elements and capacitive elements used in the filter circuit. In making the filter circuit as integrated circuit, capacitive elements and resistive elements which can be realized in the integrated circuit are used, to reduce the number of components outside the integrated circuit.

The document US 2005/156661 A1 discloses an example of such a filter.

However, capacitive elements and resistive elements which can be realized in the integrated circuit largely fluctuate in manufacturing. The manufacturing fluctuation occurs with a percentage of few score or so percent. The manufacturing fluctuation means that actual values of the resistive elements and capacitive elements become different from desired or designed values.

The manufacturing fluctuation of capacitive elements and resistive elements causes manufacturing fluctuation also in the filter characteristic, and there are cases where a desired filter characteristic cannot be obtained. In the radio communication field, when a desired filter characteristic is not obtained, a signal of a desired frequency component cannot be extracted. In other cases, unnecessary interfering frequency components cannot be sufficiently removed, and thereby the characteristic of the radio apparatus is greatly varied. To avoid such problems, when the filter characteristic fluctuates due to manufacturing fluctuation, methods of adjusting the filter characteristic to a desired filter characteristic have been widely used. Adjustment of the filter characteristic may be performed when the integrated circuit (receiver which comprises the filter circuit) is manufactured, or performed at predetermined cycles when the integrated circuit is actually used after manufacturing, such as when the integrated circuit is powered and/or being used. In every case, it is desirable that adjustment of the filter characteristic is automatically performed.

In conventional methods of automatically adjusting the filter characteristic, a standard input signal of a fixed amplitude is input to a filter, the amplitude and the phase of the output of the filter are detected by an amplitude comparator and a phase comparator while the filter characteristic is changed, and the filter characteristic is adjusted based on the amplitude and phase detection results. Specifically, the filter characteristic is roughly adjusted based on the amplitude detection result, then finely adjusted based on the phase detection result, and thereby the filter characteristic is adjusted at high accuracy. Conventional filter automatic adjusting apparatuses require a phase comparator in addition to an amplitude detector, and thus have a complicated structure. Without fine adjustment by phase comparison, it is difficult for the conventional apparatuses to secure sufficient accuracy for the filter characteristic when there is manufacturing fluctuations. For example, suppose that a reference signal of a fixed amplitude is input to the filter circuit, amplitudes of filter outputs obtained when the filter characteristic is variously adjusted are detected, and the filter characteristic relating to the highest amplitude is selected. Detection of the highest amplitude is performed by comparison of the amplitude with a threshold. In the case where the filter characteristic is a desired characteristic, the output amplitude exceeds the threshold only in the case of using the desired filter characteristic, when a proper threshold is set. However, when the filter characteristic fluctuates in a direction of increasing the gain, the output amplitudes of a plurality of filter characteristics exceed the threshold. Conversely, when the filter characteristic fluctuates in a direction of decreasing the gain, the output amplitude does not exceed the threshold in any of the filter characteristics. To avoid this problem, there is a method of preparing a plurality of amplitude detection thresholds to detect output amplitudes of a wide range. This method increases, however, the area and power consumption required for the amplitude detector.

When the filter characteristic is finely adjusted by phase detection, phase detection with high accuracy cannot be achieved with a simple structure, unless phase difference between the output signal and the input signal in a desired characteristic is set to 0° or 180°.

A general architecture that implements the various features of the embodiments will now be described with reference to the drawings. The drawings and the associated descriptions are provided to illustrate the embodiments and not to limit the scope of the invention.
FIG. 1 is an exemplary diagram of an example configuration of a filter automatic adjusting apparatus according to the first embodiment.
FIG. 2 is an exemplary flowchart illustrating an example of processing of an adjustment mode according to the first embodiment.
FIG. 3 is an exemplary diagram illustrating a state where data is stored in a memory of the first embodiment.
FIG. 4 is an exemplary diagram illustrating an example (example of using a sine wave) of a structure of a reference signal generator of the first embodiment.
FIG. 5 is an exemplary diagram illustrating another example (example of using a rectangular wave) of the structure of the reference signal generator of the first embodiment.
FIG. 6 is an exemplary diagram illustrating another example (example of using a plurality of reference signals having different frequencies) of the structure of the reference signal generator of the first embodiment.
FIG. 7 is an exemplary diagram illustrating an example of a structure of a filter of the first embodiment.
FIG. 8 is an exemplary diagram illustrating an example of a structure of an amplitude detector of the first embodiment.
FIG. 9 is an exemplary block diagram of an example of a configuration of a filter automatic adjusting apparatus according to the second embodiment.
FIG. 10 is an exemplary block diagram of an example of a configuration of a filter automatic adjusting apparatus according to the third embodiment.
FIG. 11 is an exemplary block diagram of an example of a configuration of a power adjusting system according to the fourth embodiment.

Various embodiments will be described hereinafter with reference to the accompanying drawings. In general, according to one embodiment, a filter adjusting apparatus comprises a reference signal generator; a setting module; an amplitude detector; and a determining module. The reference signal generator is configured to generate a reference signal having an amplitude set by an amplitude control signal. The setting module is configured to set different filter characteristics to the filter, and to set different amplitudes of the reference signal. The amplitude detector is configured to detect amplitudes of a filter output with reference to the reference signal having the different amplitudes. The determining module is configured to determine a desired characteristic control signal in accordance with the amplitudes detected by the amplitude detector.

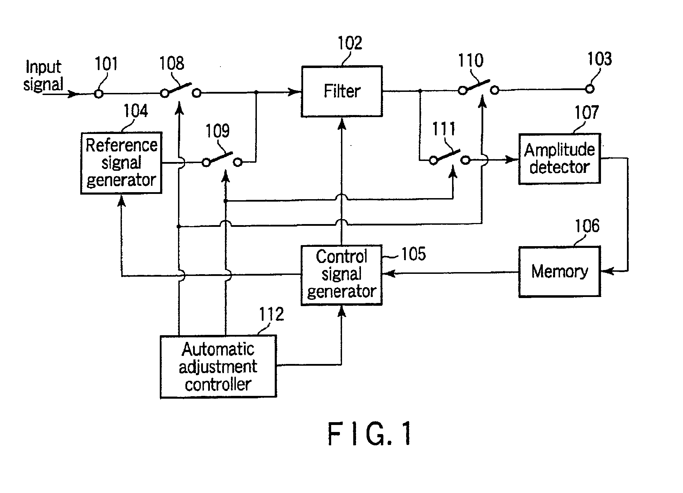

FIG. 1 is a block diagram of a filter automatic adjusting apparatus according to the first embodiment. The filter automatic adjusting apparatus comprises an input terminal 101, a filter 102, an output terminal 103, a reference signal generator 104, a control signal generator 105, a memory 106, an amplitude detector 107, a switch 108, a switch 109, a switch 110, a switch 111, and an automatic adjustment controller 112.

The input terminal 101 is a terminal configured to input an input signal from the outside to the filter 102. The input terminal 101 is connected to an input terminal of the filter 102 through the switch 108. The reference signal generator 104 generates reference signals which have different amplitudes. The details of the reference signals generated by the reference signal generator 104 will be described later. The reference signals output from the reference signal generator 104 are input to the filter 102 through the switch 109.

The output signal of the filter 102 is input to the amplitude detector 107 through the switch 111, and supplied to the output terminal 103 through the switch 110. The amplitude detector 107 detects the amplitude of the output signal of the filter 102. The details of the amplitude detector 107 will be described later. The output terminal 103 is a terminal configured to output the output signal of the filter 102 to the outside.

The filter 102 comprises a control terminal to which a filter characteristic control signal that is output from the control signal generator 105 is input. The filter characteristic (characteristic frequency) of the filter 102 can be adjusted in accordance with the filter characteristic control signal. As the filter 102, a low-pass filter, a high-pass filter, or a band-pass filter is used. The characteristic frequency is a frequency which indicates the filter characteristic. For example, in a band-pass filter, the characteristic frequency is a center frequency of the pass band. In a low-pass filter and a high-pass filter, a frequency which is cut off corresponds to the characteristic frequency. The details of the structure of the filter 102 will be described later.

A detection result of the amplitude detector 107 is written in the memory 106, and data read from the memory 106 is supplied to the control signal generator 105. The control signal generator 105 is controlled by an automatic control adjustment signal from the automatic adjustment controller 112 which is a CPU or the like. The control signal generator 105 outputs a filter characteristic control signal which controls the characteristic frequency of the filter 102, and an amplitude control signal which controls the amplitude of reference signals generated by the reference signal generator 104. Therefore, the characteristic frequency of the filter 102 and the amplitude of the reference signals generated by the reference signal generator 104 are controlled by the control signal generator 105. The filter characteristic control signal and the amplitude control signal are provided as signals which discretely change, such as digital signals. The control signal generator 105 determines a filter characteristic control signal such that the characteristic frequency of the filter becomes a desired characteristic frequency, in accordance with the data read from the memory 106 described later.

The automatic adjustment controller 112 outputs an automatic adjustment control signal which controls the switches 108, 109, 110, and 111 and the control signal generator 105. The switches 108, 109, 110, and 111 are turned on and off by the automatic adjustment control signal. For example, when an input signal from the input terminal 101 is to be input to the filter 102, the switches 108 and 110 are turned on (closed), and the switches 109 and 111 are turned off (opened). Conversely, when the switches 108 and 110 are turned off and the switches 109 and 111 are turned on, the reference signals from the reference signal generator 104 are input to the filter 102. The apparatus may comprise a mechanism for stopping output of reference signals from the reference signal generator 104, instead of using the switch 109, when input of reference signals output from the reference signal generator 104 to the filter 102 is to be stopped. The filter automatic adjustment apparatus of the first embodiment is changed between two modes, that is, an operation mode and an adjustment mode, by turning on and off the switches 108 and 110 and the switches 109 and 111.

The adjustment mode is a mode of determining a filter characteristic control signal to set the filter characteristic to a desired characteristic, based on the amplitudes of the output signals of the filter output when a plurality of reference signals having different amplitudes are input to the filter 102 which is set to a plurality of filter characteristics. In the adjustment mode, the automatic adjustment controller 112 turns off the switches 108 and 110, and turns on the switches 109 and 111. Reference signals output from the reference signal generator 104 are input to the filter 102 through the switch 109. The input reference signals are processed by the filter 102, and outputs thereof are input to the amplitude detector 107. The amplitude detector 107 detects amplitudes of the output signals of the filter 102, and stores values of the amplitudes in the memory 106. Specifically, amplitude detection is performed for all the amplitudes by changing the level of the output amplitude of the reference signal one by one in each characteristic frequency, while the level of the filter characteristic frequency is changed one by one. The amplitude of the filter output for each reference signal is associated with the output amplitude of the reference signal and the characteristic frequency which is to be set by the filter characteristic control signal, and they are written in the memory 106.

As described above, the amplitude of the filter output is detected multiple times by using a plurality of reference signals of different amplitudes while the filter characteristic is changed. Thereby, even when the filter characteristic is fluctuated, when difference is detected in filter outputs of a reference signal of any amplitude, the filter characteristic can be adjusted with high accuracy without detecting the phase.

The operation mode is a mode in which an input signal from the input terminal 101 is input to the filter 102 through the switch 108. The control terminal of the filter 102 is supplied with a filter characteristic control signal which is determined in the adjustment mode from the control signal generator 105. In the operation mode, the filter 102 extracts a desired frequency component from the input signal from the input terminal 101, and removes an unnecessary frequency component from the input signal, an output signal of the filter 102 is output through the output terminal 103.

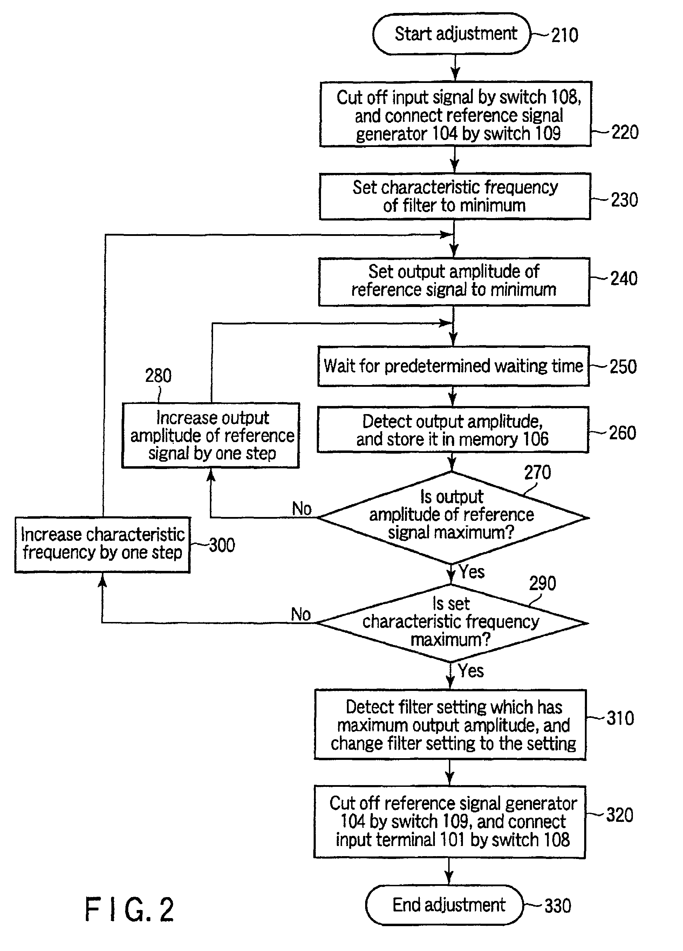

FIG. 2 is a flowchart which relates to the adjustment mode of the present embodiment.

In Block 220, the automatic adjustment controller 112 turns off the switches 108 and 110, turns on the switches 109 and 111, thereby cutting off the input signal from the input terminal 101, and inputting the reference signals from the reference signal generator 104 to the filter 102. In Block 230, the control signal generator 105 supplies a filter characteristic control signal to set the characteristic frequency to a settable minimum frequency to the filter 102. The filter characteristic control signal from the control signal generator 105 is a signal which increases and decreases the values of the resistive element and the capacitive element of the filter 102 in order to control the characteristic frequency. When the resistive element and the capacitive element are manufactured as designed, the characteristic frequency can be accurately set to a desired frequency by the control signal. However, when the resistive element and the capacitive element have manufacturing fluctuations, the characteristic frequency is not set to the desired frequency which is to be set by the control signal.

In Block 240, the control signal generator 105 supplies the reference signal generator 104 with an amplitude control signal to set the output amplitude of the reference signal, which the reference signal generator 104 generates, to a settable minimum amplitude.

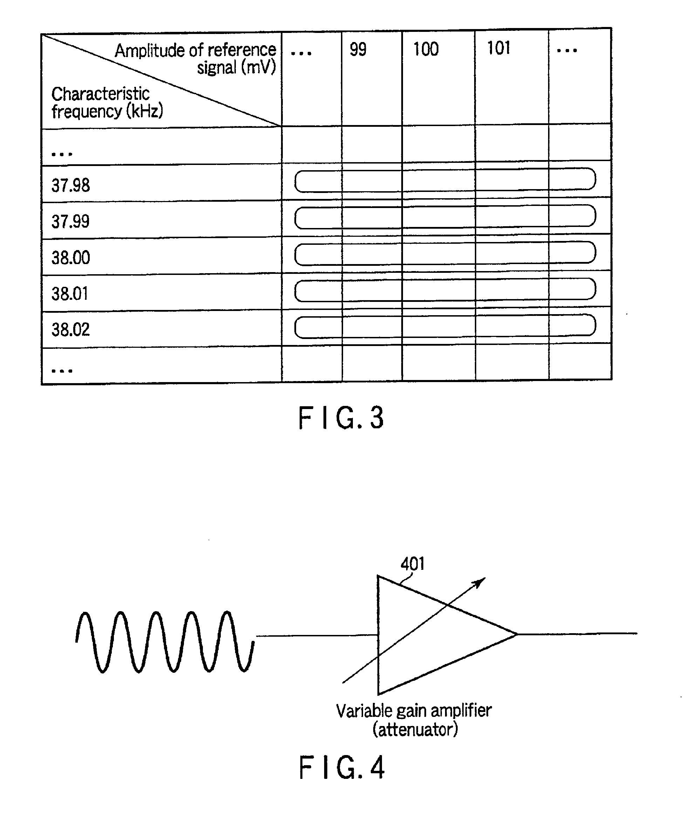

To detect the amplitude of the output signal of the filter 102, the apparatus waits for a predetermined waiting time until the signal is output from the filter 102 in Block 250. Thereafter, in Block 260, the amplitude detector 107 detects the output signal of the filter 102, and the detected output amplitude is written in the memory 106. The output amplitude of the filter 102 is stored in association with the output amplitude of the reference signal detected when the output amplitude is detected, and a characteristic frequency which is to be set by the filter characteristic control signal. FIG. 3 is a schematic diagram illustrating a state of data stored in the memory 106.

In Block 270, it is determined whether the output amplitude of the reference signal output from the reference signal generator 104 is maximum or not. When the output amplitude is not maximum, in Block 280, the control signal generator 105 increases the amplitude, which is to be set by the amplitude control signal supplied to the reference signal generator 104, by one level, and thereby increases the output amplitude of the output reference signal of the reference signal generator 104 by one level. Thereby, the amplitude of the reference signal generated by the reference signal generator 104 is increased, and the flowchart returns to Block 250.

When it is determined in Block 270 that the amplitude to be set by the amplitude control signal is maximum, it is determined in Block 290 whether the characteristic frequency of the filter to be set by the filter characteristic control signal is maximum or not. When the characteristic frequency of the filter to be set by the filter characteristic control signal is not maximum, the control signal generator 105 increases in Block 300 the characteristic frequency of the filter, which is to be set by the filter characteristic control signal supplied to the filter 102, by one level. Thereby, the filter characteristic frequency is increased, and the flowchart returns to Block 240. By the above processing, when the characteristic frequency to be set by the filter characteristic control signal is changed level by level from the minimum value to the maximum value, the output amplitude of the reference signal is changed level by level from the minimum value to the maximum value. Thereby, as shown in FIG. 3, in each of combinations between output amplitudes of the reference signal and filter characteristic frequencies, the detected value of the amplitude of the output signal of the filter 102 is written in the memory 106.

In Block 290, when it is determined that the characteristic frequency of the filter 102 to be set by the filter characteristic control signal is maximum, the control signal generator 105 determines in Block 310 a filter characteristic control signal which achieves a desired filter characteristic to be used in the operation mode, based on the amplitude detection values which are stored in the memory 106. As a method of determining the filter characteristic control signal, for example, it is possible to use a method of calculating the sum of the detection results of all the amplitudes of the reference signals in each characteristic frequency (the sum of the frames of the same horizontal row in FIG. 3), and determining the filter characteristic control signal based on the calculated values. However, the determining method differs according to the type of the filter and the type of the reference signal. Generally, in the case of using a band-pass filter, a reference signal having the center frequency of the pass band is used, and a filter characteristic control signal which has the maximum sum in the characteristic frequencies is selected. For example, supposing that a reference signal of 38 kHz is input to the band-pass filter 102, the sum of the amplitudes of the filter outputs in all the amplitudes of the reference signal should be maximum, when a characteristic frequency of 38 kHz is to be set by the filter characteristic control signal. However, suppose that it is detected that the sum is maximum when another characteristic frequency, for example, a characteristic frequency of 37.99 kHz is to be set, due to manufacturing fluctuations of the filter characteristic. In such a case, a control signal which sets a characteristic frequency of 37.99 kHz should be selected, as the filter characteristic control signal to be used in the operation mode.

In Block 320, the automatic adjustment controller 112 turns on the switch 108 and the switch 110 to input the input signal to the filter 102, and turns off the switch 109 and the switch 111 to cut off input of the reference signal to the filter 102. Thereby, the filter automatic adjustment apparatus is changed from the adjustment mode to the operation mode.

Thereby, even when the characteristic frequency of the filter is fluctuated by manufacturing fluctuations of the resistive element and the capacitive element of the filter 102, a filter characteristic control signal which achieves a desired characteristic frequency of the filter 102 can be determined as follows. By using a plurality of reference signals having different amplitudes generated by the reference signal generator 104 and a filter characteristic control signal of a plurality of characteristic frequencies generated by the control signal generator 105, output amplitudes of the filter 102 are detected for various combinations between the amplitudes of the reference signals and the characteristic frequencies. The filter characteristic control signal which achieves a desired characteristic frequency of the filter 102 is determined based on the amplitude detection results.

The order of changing the amplitude of the reference signal and the characteristic frequency of the filter is not limited to the order shown in FIG. 2, but may be any order as long as the amplitude of the filter output can be detected for all the combinations. For example, in Block 230 of FIG. 2, the filter characteristic frequency may be set to the maximum value instead of the minimum value, and the output amplitude of the reference signal may be set to the maximum value in Block 240 instead of the minimum value. However, in this case, the output amplitude of the reference signal is decreased by one level in Block 280, and the filter characteristic frequency is decreased by one level in Block 300.

In addition, the output amplitude of the reference signal may be set to a certain amplitude first, and then the characteristic frequency of the filter 102 may be changed, instead of setting the characteristic frequency of the filter 102 to a certain frequency first and then changing the output amplitude of the reference signal.

Although only one type of reference signal is used in the above explanation, a plurality of types of reference signals may be used. For example, the apparatus may use a reference signal of a desired frequency (a center frequency of the pass band in the case of using a band-pass filter) and a reference signal of an interfering frequency other than the desired frequency, and may select a filter characteristic control signal to set a characteristic frequency corresponding to the maximum amplitude detection value for the reference signal of the desired frequency, among characteristic frequencies which have at least a predetermined value of a ratio of the amplitude detection value of the reference signal of the desired frequency to the amplitude detection value of the interfering frequency.

Although the amplitude and the characteristic frequency are changed level by level in Block 280 and Block 300 in the above embodiment, it is possible to use a rough adjustment step of changing one or both of the output amplitude of the reference signal and the characteristic frequency of the filter 102 at predetermined values of two or more levels.

The adjustment step of changing one or both of the level of the output amplitude of the reference signal and the level of the characteristic frequency of the filter 102 one by one is referred to as a fine adjustment step. For example, when the output amplitude of the reference signal is changed by two or more levels each time in the rough adjustment step, it is possible to estimate the range of the filter characteristic frequency in which a significant difference occurs in the output amplitude detection results (the above sums) of the filter 102. Next, the fine adjustment step of changing the level of the output amplitude of the reference signal one by one is performed only for the range of the filter characteristic frequency estimated by the rough adjustment step, and thereby the filter characteristic control signal can be adjusted with fewer steps.

When the characteristic frequency to be set by the filter characteristic control signal is changed by two or more levels each time in the rough adjustment step, it is possible to estimate the range of the filter characteristic frequency in which a significant difference occurs in the output amplitude detection results (the above sums) of the filter 102. Next, the fine adjustment step of changing the level of the characteristic frequency to be set by the filter characteristic control signal one by one is performed only for the range of the filter characteristic frequency estimated by the rough adjustment step, and thereby the filter characteristic control signal can be adjusted with fewer steps.

As described above, the time of adjusting the filter 102 can be shortened by using a rough adjustment step of changing one or both of the two control signals by the width of two or more levels.

The following is explanation of constituent elements of the filter automatic adjustment apparatus according to the present embodiment.

FIG. 4 illustrates an example of the reference signal generator 104 shown in FIG. 1. The reference signal generator 104 comprises a variable gain amplifier/attenuator 401 to amplify or attenuate the reference signal (predetermined frequency) of a fixed amplitude. The variable gain amplifier/attenuator 401 has a function of one or both of a variable amplifier and a variable attenuator. A sine signal can be used as the reference signal. The gain of the variable gain amplifier 401 is controlled by an amplitude control signal output by the control signal generator 205, and the variable gain amplifier 401 outputs the input signal as reference signal of an amplitude which is set in accordance with the amplitude control signal. Thereby, the reference signal generator 104 can generate the reference signal of a plurality of amplitudes in accordance with the amplitude control signal.

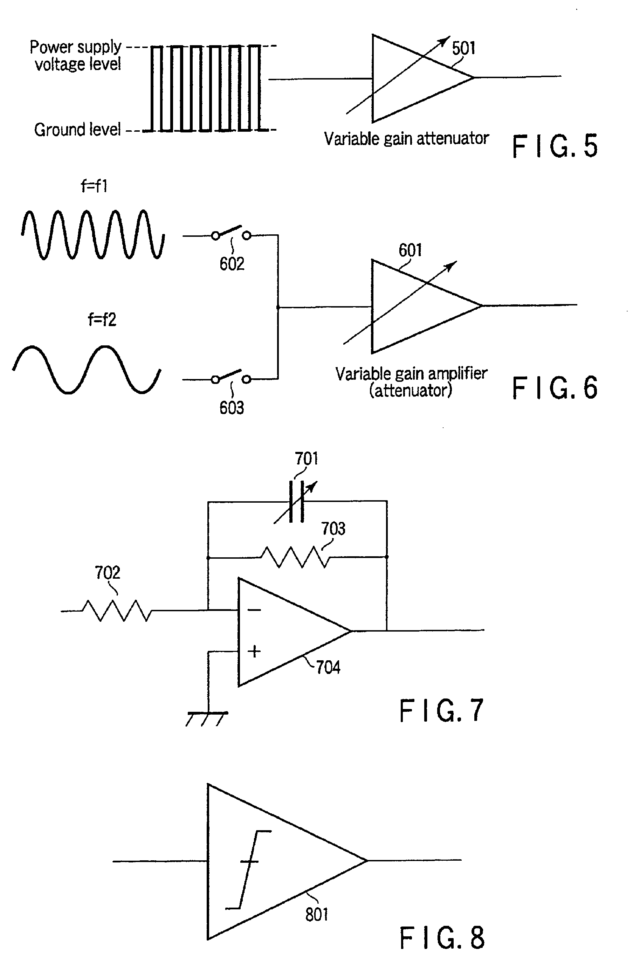

FIG. 5 illustrates another example of the structure of the reference signal generator 104. In this example, a rectangular wave signal of a reference frequency which has two values of a power supply level and a ground level is used as the reference signal, instead of a sine wave signal. Such a rectangular wave signal can be easily obtained from a clock signal which is used in an oscillator and a digital module. The amplitude of the rectangular wave signal is adjusted by using a variable gain attenuator 501.

Thereby, it is possible to easily generate the reference signal from a clock signal used in the oscillator and the digital module.

The above rectangular wave signal comprises a harmonic wave component. There are cases where the filter cannot be properly adjusted due to influence of the harmonic wave. In such cases, the reference signal generator 104 further comprises a filter to remove the harmonic wave component.

In addition to the above examples, the reference signal generator 104 may have a structure of generating a plurality of reference signals which have different frequencies in advance, and selecting one of the reference signals by a switch or the like.

As shown in FIG. 6, the reference signal generator 104 may generate a plurality of reference signals which have different frequencies in advance, select one of the reference signals by switches 602 and 603, and input the selected reference signal to a variable gain amplifier/attenuator 601. FIG. 6 illustrates two reference signals of different frequencies.

FIG. 7 illustrates a specific example of a structure of the filter 102 shown in FIG. 2, which can adjust the characteristic frequency.

The filter 102 comprises a variable capacitor 701, a resistor 702, a resistor 703, and an operational amplifier 704. An input signal is input to an inverting input terminal of the operational amplifier 704 through the input resistor 702. A non-inverting input terminal of the operational amplifier 704 is grounded. The variable capacitor 701 and the feedback resistor 703 are connected in parallel with an output terminal and the inverting input terminal of the operational amplifier 704.

The characteristic frequency of the filter 102 is changeable, by adjusting the value of the variable capacitor 701 in accordance with the filter characteristic control signal from the control signal generator 105.

The variable capacitor 701 may comprise, for example, a plurality of capacitors connected in parallel wherein connection thereof can be controlled by switches. The capacitance value thereof is varied by turning on/off the switches. In addition, the resistance values of the resistors 702 and 703 shown in FIG. 7 may be variable, and the characteristic frequency may be changed by controlling the resistance values thereof.

The filter 102 may be configured as Gm-C filter wherein the capacitance value of the Gm-C filter or a Gm value of the trans-conductance amplifier is controlled.

FIG. 8 illustrates an example of a structure of the amplitude detector 107.

A comparator 801 is used as the amplitude detector 107. The amplitude of the output signal of the filter 102 is compared with a threshold of the comparator 801, and it is determined whether the detected amplitude is larger or smaller than the threshold. Although the comparator 801 is equivalent to an A/D converter of 1 bit, an A/D converter of a desired number of bits may be used as the amplitude detector 107.

The amplitude detector 107 may have a structure of converting an input signal to a direct-current component by a rectifier, and comparing the direct-current component with a predetermined threshold by the comparator 801.

According to the first embodiment described above, it is possible to determine a filter characteristic control signal to set the filter characteristic to a desired characteristic based on the amplitudes of the output signals of the filter 102 which are obtained when the reference signals of different amplitudes are input to the filter 102 which are set to various filter characteristics. Thereby, even when the filter characteristic has manufacturing fluctuations due to manufacturing fluctuations of the resistive elements and the capacitive elements in the integrated circuit, it is possible to automatically adjust the filter characteristic with high accuracy, without a phase comparator.

The following is explanation of other embodiments. In the explanation of the other embodiments, constituent elements which are the same as those in the first embodiment are denoted by the same respective reference numerals, and detailed explanation thereof is omitted.

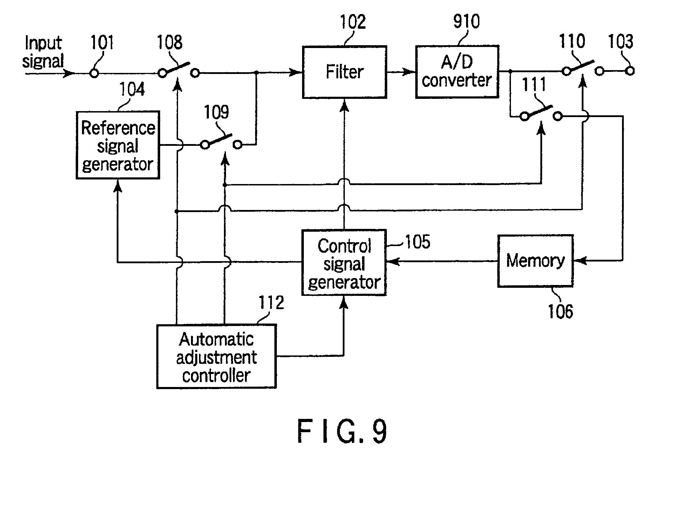

FIG. 9 is a block diagram of a filter automatic adjusting apparatus according to the second embodiment. The second embodiment is different from the first embodiment in that an A/D converter 910 is used instead of the amplitude detector 107, and connection of the A/D converter 910. In the second embodiment, an output signal of the filter 102 is input to the A/D converter 910, and an output of the A/D converter 910 is supplied to the output terminal 103 through the switch 110 and supplied to the memory 106 through the switch 111. Specifically, the A/D converter 901 can be used in both the operation mode and the adjustment mode.

Although the dedicated amplitude detector 107 is used in the first embodiment to detect the amplitude of the output signal of the filter 102, the A/D converter 910 of the second embodiment can be also used for digital signal processing, as well as detection of the amplitude of the output signal of the filter 102. Specifically, the A/D converter 910 operates as a signal processing circuit when the filter automatic adjusting apparatus is in the operation mode, and operates as an amplitude detector when the filter automatic adjusting apparatus is in the adjustment mode.

Thereby, automatic filter adjustment can be performed without adding a dedicated amplitude detector to the filter automatic adjusting apparatus.

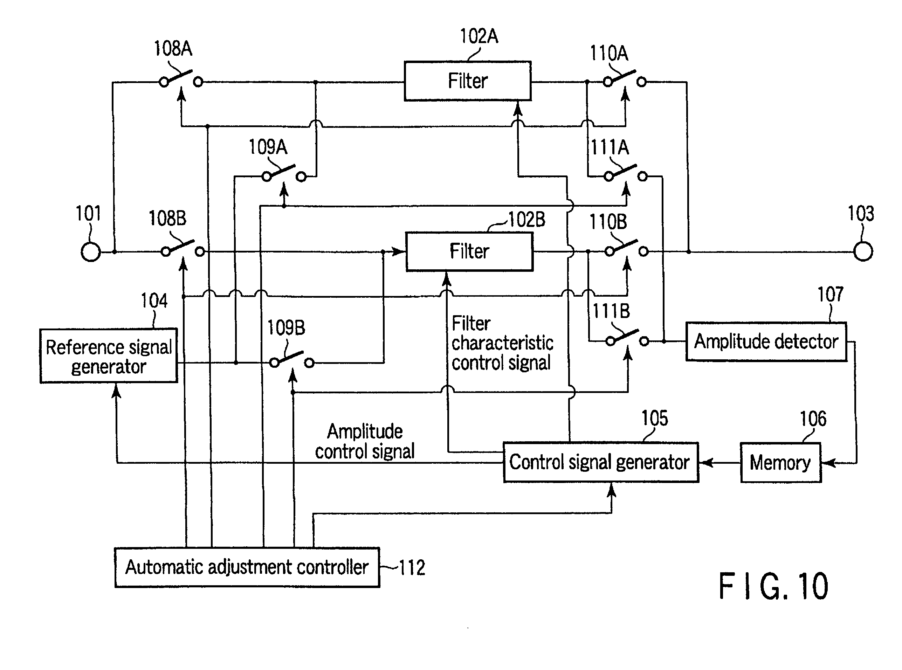

FIG. 10 is a block diagram of a filter automatic adjusting apparatus according to the third embodiment.

In the first and second embodiments, the filter is changed to the adjustment mode and the operation mode, and one of the reference signal and the input signal is input to the filter. Since in the adjustment mode the input signal is cut off and the reference signal is input to the filter, the essential operation of the filter cannot be performed. Therefore, in the adjustment mode, a radio apparatus or the like which uses the filter cannot perform signal processing. The third embodiment comprises a structure in which two filters having the same structure are provided and, when one of the filters is in the adjustment mode, the other can be used in the operation mode. When one filter is in the operation mode, it is not always necessary to use the other filter in the adjustment mode, but may be suspended when adjustment is unnecessary.

Although FIG. 10 illustrates the example where two filters are provided in the first embodiment, it is also possible to adopt a structure of providing two filters in the second embodiment. The input terminal 101 is connected to filters 102A and 102B through switches 108A and 108B. The reference signal generator 104 is connected to the filters 102A and 102B through switches 109A and 109B. An output terminal of the filter 102A is connected to the output terminal 103 through a switch 110A, and connected to the amplitude detector 107 through a switch 111A. An output terminal of the filter 102B is connected to the output terminal 103 through a switch 110B, and connected to the amplitude detector 107 through a switch 111B.

Operation of the present embodiment will be explained hereinafter. The automatic adjustment controller 112 sets one of the filters 102A and 102B to the adjustment mode, and the other to the operation mode. In this example, the filter 102A is set to the adjustment mode first, and the filter 102B is set to the operation mode. The automatic adjustment controller 112 turns off the switches 108A, 110A, 109B, and 111B, and turns on the switches 108B, 110B, 109A, and 111A. Thereby, the filter 102B receives an input signal from the input terminal 101 and operates in the operation mode, and the filter 102A receives the reference signal from the reference signal generator 104, and operates in the adjustment mode. The output of the filter 102A is supplied to the amplitude detector 107 through the switch 111A, and a filter characteristic control signal to be used in the operation mode is determined in the same manner as the first embodiment.

Thereafter, the automatic adjustment controller 112 changes the ON/OFF states of the switches at predetermined timing, and thereby changing the filter 102A from the adjustment mode to the operation mode. Thereafter, the filter 102B may be changed to the adjustment mode or a suspension mode. To change the filter 102B to the suspension mode, all the switches 108B, 109B, 110B and 111B which are connected to the input terminal and the output terminal of the filter 102B are turned off to prevent power consumption by the filter 102B.

When the filter 102B is changed to the suspension mode, the filter 102B is changed to the adjustment mode at predetermined timing. After automatic adjustment is finished, the filter 102B is changed to the operation mode at predetermined timing, and the filter 102A is changed to the adjustment mode or the suspension mode. Therefore, even when one of the filters is in the adjustment mode, the other filter operates in the operation mode, and thus it is possible to always perform processing of the input signal from the input terminal 101 in the present embodiment.

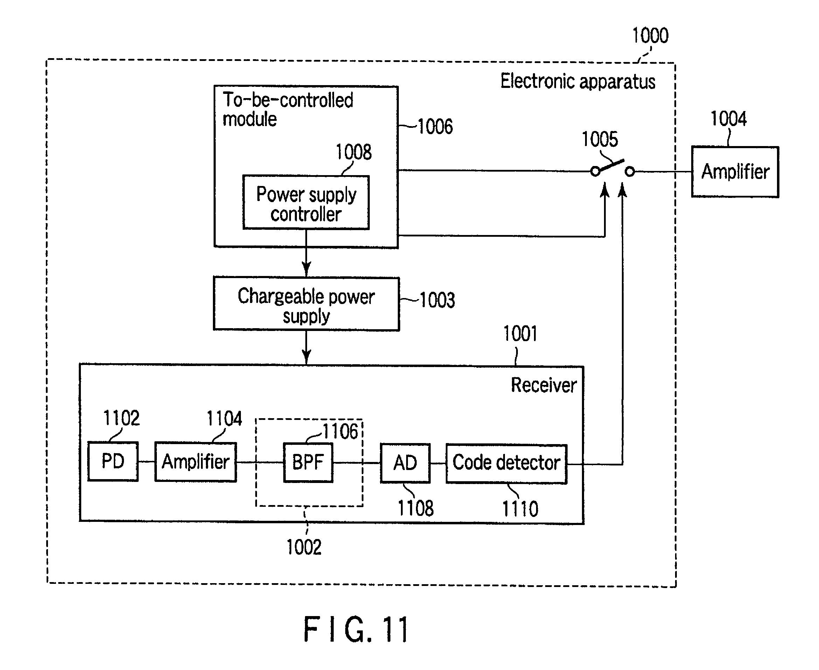

FIG. 11 is a block diagram according to the fourth embodiment. The fourth embodiment shows an application example of a receiver which comprises the filter automatic adjusting apparatus according to one of the first to third embodiments. As the application example, explained is a power supply control system wherein the receiver is comprised in an apparatus (such as television) which is controlled by a remote controller, and power consumption in the standby state of the apparatus to be controlled is controlled (reduced).

A power supply 1004 is connected to an electronic apparatus 1000. The power supply 1004 is, for example, an AC power supply of 100V, and connected to a to-be-controlled module 1006 through a switch 1005. The to-be-controlled module 1006 is supplied with electric power from the power supply 1004 when the switch 1005 is turned on. The switch 1005 is turned on and off by a control signal from the to-be-controlled module 1006 or a control signal from a receiver 1001. The to-be-controlled module 1006 comprises a power supply controller 1008 which controls a chargeable power supply 1003 based on the electric power supplied from the power supply 1004. The chargeable power supply 1003 is charged by the electric power from the power supply controller 1008. The electric power output by the chargeable power supply 1003 is sufficiently smaller than the electric power output by the power supply 1004.

The receiver 1001 comprises a photodiode (PD) 1102 which receives an infrared remote control signal from a remote controller (not shown), an amplifier 1104 which amplifies the output of the photodiode 1102, a band-pass filter 1106 which is supplied with the output of the amplifier 1104, and a code detector 1110 which is supplied with the output of the band-pass filter 1106 through an A/D converter 1108. The band-pass filter 1106 extracts a sub-carrier wave of the remote control signal which is PPM-modulated. The code detector 1110 detects various control codes included in the remote control signal.

The band-pass filter 1106 is included in a filter automatic control apparatus 1002 which is described in one of the first embodiment to the third embodiment. The receiver 1001 is operated by electric power supplied from the chargeable power supply 1003. Therefore, the receiver 1001 can operate with electric power sufficiently smaller than that of the to-be-controlled module 1006.

Operation of the present embodiment will be specifically explained hereinafter. When the to-be-controlled module 1006 is operated, the switch 1005 is in the ON state, and the to-be-controlled module 1006 is supplied with electric power from the power supply 1004. A predetermined voltage is supplied to the chargeable power supply 1103 through the power supply controller 1008 included in the to-be-controlled module 1006. Therefore, the chargeable power supply 1003 is charged, if necessary, during operation of the to-be-controlled module 1006.

The to-be-controlled module 1006 is changed to a standby state under predetermined conditions. The predetermined conditions comprises the case where, for example, the to-be-controlled module 1006 receives a command to be changed to the standby state, and the case where the receiver 1001 receives a remote control signal which changes the to-be-controlled module 1006 to the standby state. In these cases, the to-be-controlled module 1006 or the receiver 1001 turns off the switch 1005, and shuts off the to-be-controlled module 1006 from the power supply 1004. Thereby, the to-be-controlled module 1006 is changed to a state in which the to-be-controlled module 1006 does not consume electric power, and only the receiver 1001 operates in the standby state. Since the receiver 1001 operates by electric power from the chargeable power supply 1003, the receiver 1001 operates with power consumption sufficiently smaller than that of the to-be-controlled module 1006. Thereby, power consumption in the standby state can be reduced.

In the standby state, when the receiver 1001 receives a remote control signal to change the to-be-controlled module 1006 to the operation state, the receiver 1001 turns on the switch 1005, and connects the power supply 1004 to the to-be-controlled module 1006.

In the present embodiment, automatic adjustment of the filter is performed in the operation state of the apparatus. When automatic adjustment is performed in the standby mode, there is the possibility that a signal to change the apparatus to the operation state cannot be received. When automatic adjustment is performed in the operation state, a signal to change the apparatus to the operation state can be surely received in the standby state.

Specifically, automatic adjustment is performed within a predetermined time directly after the apparatus is changed to the operation state. When it is necessary for the receiver 1001 to receive a signal to change the apparatus from the operation state to the standby state, the signal cannot be received during automatic adjustment. However, by performing automatic adjustment directly after the apparatus is changed to the operation state, there is only the restriction that a signal to change the apparatus from the operation state to the standby state cannot be received only directly after the apparatus is changed to the operation state. When it is unnecessary to frequently change the apparatus between the operation state and the standby state, the above restriction does not cause any problem. In the same manner, automatic adjustment of the filter may be performed directly after the apparatus is changed from the operation state to the standby state.

Thereby, it is possible to reduce power consumption of the to-be-controlled module 1006, when the to-be-controlled module 1006 is in the standby state.

The various modules of the systems described herein can be implemented as software applications, hardware and/or software modules, or components on one or more computers, such as servers. While the various modules are illustrated separately, they may share some or all of the same underlying logic or code.

## Claims

1. A filter adjusting apparatus **characterized by** comprising:
a filter (102) having a filter characteristic controllable by a characteristic control signal;
a reference signal generator (104) configured to generate a reference signal having an amplitude set by an amplitude control signal wherein the reference signal is supplied to the filter;
a setting module (105) configured to set different filter characteristics to the filter by the characteristic control signal, and to set different amplitudes of the reference signal by the amplitude control signal;
an amplitude detector (107) configured to detect amplitudes of an output signal of the filter with reference to the reference signal having the different amplitudes in each of the filter characteristics set by the characteristic control signal; and
a determining module (112) configured to determine a desired characteristic control signal for setting a desired filter characteristic in accordance with the amplitudes detected by the amplitude detector.

2. The apparatus of Claim 1, **characterized by** further comprising:
a selector (108, 109) configured to selectively input one of an external input signal and the reference signal to the filter.

3. The apparatus of Claim 1, **characterized in that**
the amplitude detector (107) comprises a converter (910) configured to convert an analog signal to a digital signal.

4. The apparatus of Claim 1, **characterized in that**
the reference signal comprises a rectangular wave signal.

5. The apparatus of Claim 1, **characterized in that**
the reference signal generator (104) comprises a variable gain module (401) configured to amplify or attenuate a fixed input signal with a variable gain.

6. The apparatus of Claim 1, **characterized in that**
the filter (102) comprises a band-pass filter, the reference signal comprises a signal having a frequency of a pass band of the band-pass filter, and
the determining module (112) configured to determine a characteristic control signal for setting a filter characteristic wherein the amplitude detector is configured to detect a maximum amplitude of an output signal of the filter as the desired characteristic control signal.

7. The apparatus of Claim 1, **characterized in that**
the filter (102) comprises a first filter and a second filter,
the reference signal generator is configured to supply the reference signal having the different amplitudes to one of the first filter and the second filter, and
the amplitude detector (107) is configured to detect amplitudes of an output signal of one of the first filter and the second filter to which the reference signal is supplied.

8. The apparatus of Claim 1, **characterized in that**
the setting module (105) is configured to generate a first characteristic control signal for setting a first filter characteristic, to successively generate an amplitude control signal for successively changing an amplitude of the reference signal wherein the filter characteristic is maintained, and to generate a second characteristic control signal for setting a second filter characteristic when the amplitude of the reference signal is varied to the different amplitudes.

9. The apparatus of Claim 1, **characterized in that**
the setting module (105) is configured to generate a first amplitude control signal for setting an amplitude of the reference signal to a first amplitude, to successively generate a characteristic control signal for successively changing a filter characteristic wherein the amplitude is maintained, and to generate a second amplitude control signal for setting an amplitude of the reference signal to a second amplitude when the filter characteristic signal is in a state where the amplitude is maintained.

10. The apparatus of Claim 1, **characterized in that**
the setting module (105) is configured to roughly set at least one of a first filter characteristic and a first amplitude, to finely set a second filter characteristic within a characteristic control signal range including the desired characteristic control signal after the determining module determines the characteristic control signal range, and to finely set a second amplitude of the reference signal by the amplitude control signal.

11. A power supply control system **characterized by** comprising:
a target apparatus (1006) supplied with power;
a switch (1005) connected between the target apparatus (1006) and a first power supply (1004), the switch (1005) being on when the target apparatus (1006) is in an operating state and off when the target apparatus (1006) is in a standby state;
a second power supply (1003) charged by the first power supply (1004); and
a receiver (1001) comprising a filter adjusting apparatus (1002) powered by the second power supply (1003), wherein the filter adjusting apparatus (1002) according to claim 1. , wherein
the receiver (1001) is configured to turn on the switch (1005) when the target apparatus (1006) is in the standby state and the receiver (1001) receives a signal to change the target apparatus (1006) from the standby state to the operation state.

12. An adjusting method for a filter having a filter characteristic controllable by a characteristic control signal, the method **characterized by** comprising:
setting different filter characteristics to the filter by the characteristic control signal wherein a reference signal having different amplitudes;
detecting amplitudes of an output signal of the filter with reference to the reference signal having the different amplitudes in each of filter characteristics; and
determining a desired characteristic control signal for setting a desired filter characteristic in accordance with the detected amplitudes.

13. The method of Claim 12, **characterized by** further comprising:
selectively inputting one of an external input signal and the reference signal to the filter.

14. The method of Claim 12, **characterized in that**
the amplitudes are detected by using a converter configured to convert an analog signal to a digital signal.

15. The method of Claim 12, **characterized in that**
the reference signal comprises a rectangular wave signal.

16. The method of Claim 12, **characterized in that**
the filter comprises a band-pass filter,
the reference signal comprises a signal having a frequency of a pass band of the band-pass filter, and
a characteristic control signal for setting a filter characteristic is determined as the desired characteristic control signal wherein a maximum amplitude of an output signal of the filter is detected.

17. The method of Claim 12, **characterized by** further comprising:
generating a first characteristic control signal for setting a first filter characteristic;
successively generating an amplitude control signal for successively changing an amplitude of the reference signal wherein the filter characteristic is maintained; and
generating a second characteristic control signal for setting a second filter characteristic when the amplitude of the reference signal is varied to the different amplitudes.

18. The method of Claim 12, **characterized by** further comprising:
generating a first amplitude control signal for setting an amplitude of the reference signal to a first amplitude;
successively generating a characteristic control signal for successively changing a filter characteristic in a state where the amplitude is maintained; and
generating a second amplitude control signal for setting an amplitude of the reference signal to a second amplitude when the filter characteristic signal is in a state where the amplitude is maintained.

19. The method of Claim 12, **characterized by** further comprising:
roughly setting at least one of a first filter characteristic and a first amplitude;
determining a characteristic control signal range including the desired characteristic control signal;
finely setting a second filter characteristic within the characteristic control signal range; and
finely setting a second amplitude of the reference signal by the amplitude control signal.

## Patentansprüche

1. Filtereinstellvorrichtung, **gekennzeichnet durch**:
ein Filter (102) mit einer Filtercharakteristik, die durch ein Charakteristiksteuersignal gesteuert werden kann;
einen Bezugssignalgenerator (104), der ausgestaltet ist, um ein Bezugssignal mit einer Amplitude zu erzeugen, die von einem Amplitudensteuersignal eingestellt wird, wobei das Bezugssignal dem Filter zugeführt wird;
ein Einstellmodul (105), das ausgestaltet ist, um verschiedene Filtercharakteristika des Filters **durch** das Charakteristiksteuersignal einzustellen, und um verschiedene Amplituden des Bezugssignals **durch** das Amplitudensteuersignal einzustellen;
einen Amplitudendetektor (107), der ausgestaltet ist, um die Amplituden eines Ausgabesignals des Filters zu erfassen, unter Bezug auf das Bezugssignal mit unterschiedlichen Amplituden in jeder der Filtercharakteristika, die von dem Charakteristiksteuersignal eingestellt werden; und
ein Bestimmungsmodul (112), das ausgestaltet ist, um ein gewünschtes Charakteristiksteuersignal zu bestimmen, um eine gewünschte Filtercharakteristik in Übereinstimmung mit den Amplituden einzustellen, die von dem Amplitudendetektor erfasst werden.

2. Vorrichtung nach Anspruch 1, **dadurch gekennzeichnet, dass** sie des Weiteren umfasst:
eine Auswahlvorrichtung (108, 109), die ausgestaltet ist, um selektiv ein externes Eingabesignal oder das Bezugssignal in das Filter einzugeben.

3. Vorrichtung nach Anspruch 1, **dadurch gekennzeichnet, dass**
der Amplitudendetektor (107) einen Konverter (910) umfasst, der ausgestaltet ist, um ein Analogsignal in ein Digitalsignal zu wandeln.

4. Vorrichtung nach Anspruch 1, **dadurch gekennzeichnet, dass**
das Bezugssignal ein Rechteckwellensignal umfasst.

5. Vorrichtung nach Anspruch 1, **dadurch gekennzeichnet, dass**
der Bezugssignalgenerator (104) ein Modul mit variabler Verstärkung (401) umfasst, das ausgestaltet ist, um ein festes Eingabesignal mit einer variablen Verstärkung zu verstärken oder zu dämpfen.

6. Vorrichtung nach Anspruch 1, **dadurch gekennzeichnet, dass**
das Filter (102) ein Bandpassfilter umfasst,
wobei das Bezugssignal ein Signal mit der Frequenz eines Durchlassbandes des Bandpassfilters hat, und
wobei das Bestimmungsmodul (112) ausgestaltet ist, um ein Charakteristiksteuersignal zum Einstellen einer Filtercharakteristik zu bestimmen, wobei der Amplitudendetektor ausgestaltet ist, um eine maximale Amplitude eines Ausgabesignals des Filters als das gewünschte Charakteristiksteuersignal zu erfassen,.

7. Vorrichtung nach Anspruch 1, **dadurch gekennzeichnet, dass**
das Filter (102) ein erstes Filter und ein zweites Filter umfasst,
der Bezugssignalgenerator ausgestaltet ist, um das Bezugssignal mit unterschiedlichen Amplituden an das erste Filter oder das zweite Filter zu liefern, und
der Amplitudendetektor (107) ausgestaltet ist, um Amplituden eines Ausgabesignals von dem ersten Filter oder dem zweiten Filter zu erfassen, zu dem das Bezugssignal zugeführt wird.

8. Vorrichtung nach Anspruch 1, **dadurch gekennzeichnet, dass**
das Einstellmodul (105) ausgestaltet ist, um ein erstes Charakteristiksteuersignal zu erzeugen, um eine erste Filtercharakteristik einzustellen, um sukzessiv ein Amplitudensteuersignal zu erzeugen, um sukzessiv eine Amplitude des Bezugssignals zu ändern, bei der die Filtercharakteristik beibehalten wird, und um ein zweites Charakteristiksteuersignal zu erzeugen, um eine zweite Filtercharakteristik einzustellen, wenn die Amplitude des Bezugssignals auf die unterschiedlichen Amplituden geändert wird.

9. Vorrichtung nach Anspruch 1, **dadurch gekennzeichnet, dass**
das Einstellmodul (105) ausgestaltet ist, um ein erstes Amplitudensteuersignal zu erzeugen, um eine Amplitude des Bezugssignals auf eine erste Amplitude einzustellen, um sukzessiv ein Charakteristiksteuersignal zu erzeugen, um sukzessiv eine Filtercharakteristik zu ändern, bei der die Amplitude beibehalten wird, und um ein zweites Amplitudensteuersignal zu erzeugen, um eine Amplitude des Bezugssignals auf die zweite Amplitude einzustellen, wenn das Filtercharakteristiksignal in einem Zustand ist, in dem die Amplitude beibehalten wird.

10. Vorrichtung nach Anspruch 1, **dadurch gekennzeichnet, dass**
das Einstellmodul (105) ausgestaltet ist, um grob zumindest eines von einer ersten Filtercharakteristik und einer ersten Amplitude einzustellen, um fein eine zweite Filtercharakteristik innerhalb eines Charakteristiksteuersignalbereiches einzustellen, der das gewünschte Charakteristiksteuersignal enthält, nachdem das Bestimmungsmodul den Charakteristiksteuersignalbereich bestimmt hat, und um fein die zweite Amplitude des Bezugssignals durch das Amplitudensteuersignal einzustellen.

11. Leistungszufuhrsteuersystem, **dadurch gekennzeichnet, dass** es umfasst:
eine Zielvorrichtung (1006), der Leistung zugeführt wird;
einen Schalter (1005), der zwischen der Zielvorrichtung (1006) und einer ersten Leistungszufuhr (1004) verbunden ist, wobei der Schalter (1005) an ist, wenn die Zielvorrichtung (1006) in einem Betriebszustand ist, und der aus ist, wenn die Zielvorrichtung (1006) in einem Standby-Zustand ist;
eine zweite Leistungsversorgung (1003), die von der ersten Leistungsversorgung (1004) geladen wird; und
einen Empfänger (1001) mit einer Filtereinstellvorrichtung (1002), die von dem der zweiten Leistungsversorgung (1003) mit Leistung versorgt wird,
wobei die Filtereinstellvorrichtung (1002) entsprechend Anspruch 1 ausgebildet ist,
wobei der Empfänger (1001) ausgestaltet ist, um den Schalter (1005) anzuschalten, wenn die Zielvorrichtung (1006) in einem Standby-Zustand ist und der Empfänger (1001) ein Signal zum Ändern der Zielvorrichtung (1006) von dem Standby-Zustand in den Betriebszustand empfängt.

12. Einstellverfahren für ein Filter mit einer Filtercharakteristik, die durch ein Charakteristiksteuersignal steuerbar ist, wobei das Verfahren **gekennzeichnet ist durch**:
Einstellen unterschiedlicher Filtercharakteristika des Filters **durch** das Charakteristiksteuersignal, bei denen ein Bezugssignal unterschiedliche Amplituden hat;
Erfassen der Amplituden eines Ausgabesignals des Filters unter Bezug auf das Bezugssignal mit den unterschiedlichen Amplituden in jeder der Filtercharakteristika; und
Bestimmen eines gewünschten Charakteristiksteuersignals zum Einstellen einer gewünschten Filtercharakteristik in Übereinstimmung mit den erfassten Amplituden.

13. Verfahren nach Anspruch 12, **gekennzeichnet durch**:
selektives Eingeben eines externen Eingabesignals oder des Bezugssignals in das Filter.

14. Verfahren nach Anspruch 12, **dadurch gekennzeichnet, dass**
die Amplituden unter Verwendung eines Konverters erfasst werden, der ausgestaltet ist, um ein Analogsignal in ein Digitalsignal zu wandeln.

15. Verfahren nach Anspruch 12, **dadurch gekennzeichnet, dass**
das Bezugssignal ein Rechteckwellensignal umfasst.

16. Verfahren nach Anspruch 12, **dadurch gekennzeichnet, dass**
das Filter ein Bandpassfilter umfasst,
das Bezugssignal ein Signal umfasst, das eine Frequenz eines Durchlassbandes des Bandpassfilters hat, und
ein Charakteristiksteuersignal zum Einstellen einer Filtercharakteristik als das gewünschte Charakteristiksteuersignal bestimmt wird, bei dem eine maximale Amplitude eines Ausgabesignals des Filters erfasst wird.

17. Verfahren nach Anspruch 12, **dadurch gekennzeichnet, dass** es des Weiteren umfasst:
Erzeugen eines ersten Charakteristiksteuersignals zum Einstellen einer ersten Filtercharakteristik;
sukzessives Erzeugen eines Amplitudensteuersignals zum sukzessiven Ändern einer Amplitude des Bezugssignals, wobei die Filtercharakteristik beibehalten wird; und
Erzeugen eines zweiten Charakteristiksteuersignals zum Einstellen einer zweiten Filtercharakteristik, wenn die Amplitude des Bezugssignals auf die unterschiedlichen Amplituden geändert wird.

18. Verfahren nach Anspruch 12, **gekennzeichnet durch**:
Erzeugen eines ersten Amplitudensteuersignals zum Einstellen einer Amplitude des Bezugssignals auf eine erste Amplitude;
sukzessives Erzeugen eines Charakteristiksteuersignals zum sukzessiven Ändern einer Filtercharakteristik in einem Zustand, in dem die Amplitude beibehalten wird; und
Erzeugen eines zweiten Amplitudensteuersignals zum Einstellen einer Amplitude des Bezugssignals auf eine zweite Amplitude, wenn das Filtercharakteristiksignal in einem Zustand ist, in dem die Amplitude beibehalten wird.

19. Verfahren nach Anspruch 12, **gekennzeichnet durch**:
grobes Einstellen von zumindest einem von einer ersten Filtercharakteristik und einer ersten Amplitude;
Bestimmen eines Charakteristiksteuersignalbereiches, der das gewünschte Charakteristiksteuersignal enthält;
feines Einstellen einer zweiten Filtercharakteristik innerhalb des Charakteristiksteuersignalbereiches; und
feines Einstellen einer zweiten Amplitude des Bezugssignals **durch** das Amplitudensteuersignal.

## Revendications

1. Dispositif de réglage de filtre **caractérisé en ce qu'**il comprend :
un filtre (102) ayant une caractéristique de filtre pouvant être commandée par un signal de commande de caractéristique ;
un générateur de signal de référence (104) configuré pour générer un signal de référence ayant une amplitude réglée par un signal de commande d'amplitude dans lequel le signal de référence est fourni au filtre ;
un module de réglage (105) configuré pour régler différentes caractéristiques de filtre pour le filtre par le signal de commande de caractéristique, et pour régler des amplitudes différentes du signal de référence par le signal de commande d'amplitude ;
un détecteur d'amplitude (107) configuré pour détecter des amplitudes d'un signal de sortie du filtre en se référant au signal de référence ayant les amplitudes différentes dans chacune des caractéristiques de filtre réglée par le signal de commande de caractéristique ; et
un module de détermination (112) configuré pour déterminer un signal de commande de caractéristique souhaitée selon les amplitudes détectées par le détecteur d'amplitude.

2. Dispositif selon la revendication 1, **caractérisé en ce qu'**il comprend en outre :
un sélecteur (108, 109) configuré pour entrer sélectivement l'un d'un signal d'entrée extérieur et du signal de référence vers le filtre.

3. Dispositif selon la revendication 1, **caractérisé en ce que**
le détecteur d'amplitude (107) comprend un convertisseur (910) configuré pour convertir un signal analogique en un signal numérique.

4. Dispositif selon la revendication 1, **caractérisé en ce que**
le signal de référence comprend un signal d'onde rectangulaire.

5. Dispositif selon la revendication 1, **caractérisé en ce que**
le générateur de signal de référence (104) comprend un module à gain variable (401) configuré pour amplifier ou atténuer un signal d'entrée fixe avec un gain variable.

6. Dispositif selon la revendication 1, **caractérisé en ce que**
le filtre (102) comprend un filtre passe-bande,
le signal de référence comprend un signal ayant une fréquence de bande passante du filtre passe-bande, et
le module de détermination (112) configuré pour déterminer un signal de commande de caractéristique pour régler une caractéristique de filtre dans lequel le détecteur d'amplitude est configuré pour détecter une amplitude maximum d'un signal de sortie du filtre comme le signal de commande de caractéristique souhaitée.

7. Dispositif selon la revendication 1, **caractérisé en ce que**
le filtre (102) comprend un premier filtre et un second filtre,
le générateur de signal de référence est configuré pour fournir le signal de référence ayant les amplitudes à l'un du premier filtre et du second filtre, et
le détecteur d'amplitude (107) est configuré pour détecter des amplitudes d'un signal de sortie de l'un du premier filtre et du second filtre auquel le signal de référence est fourni.

8. Dispositif selon la revendication 1, **caractérisé en ce que**
le module de réglage (105) est configuré pour générer un premier signal de commande de caractéristique pour régler une caractéristique de premier filtre, pour générer successivement un signal de commande d'amplitude pour changer successivement une amplitude du signal de référence en maintenant la caractéristique de filtre, et pour générer un second signal de commande de caractéristique pour régler une caractéristique de second filtre quand l'amplitude du signal de référence varie aux amplitudes différentes.

9. Dispositif selon la revendication 1, **caractérisé en ce que**
le module de réglage (105) est configuré pour générer un premier signal de commande d'amplitude pour régler une amplitude du signal de référence à une première amplitude, pour générer successivement un signal de commande de caractéristique pour changer successivement une caractéristique de filtre dans lequel l'amplitude est maintenue, et pour générer un second signal de commande d'amplitude pour régler une amplitude du signal de référence à une seconde amplitude quand le signal de caractéristique de filtre est dans un état où l'amplitude est maintenue.

10. Dispositif selon la revendication 1, **caractérisé en ce que**
le module de réglage (105) est configuré pour régler grossièrement au moins une d'une caractéristique de premier filtre et d'une première amplitude, pour régler finement une caractéristique de second filtre dans une plage de signal de commande de caractéristique incluant le signal de commande de caractéristique souhaitée après que le module de détermination a déterminé la plage de signal de commande de caractéristique, et pour régler finement une seconde amplitude du signal de référence par le signal de commande d'amplitude.

11. Système de commande d'alimentation électrique **caractérisé en ce qu'**il comprend :
un appareil cible (1006) alimenté en électricité ;
un commutateur (1005) connecté entre l'appareil cible (1006) et une première alimentation électrique (1004), le commutateur (1005) étant allumé quand l'appareil cible (1006) est dans un état fonctionnel et éteint quand l'appareil cible (1006) est dans un état de veille ;
une seconde alimentation électrique (1003) chargée par la première alimentation électrique (1004) ; et
un récepteur (1001) comprenant un dispositif de réglage de filtre (1002) alimenté par la seconde alimentation électrique (1003),
dans lequel le dispositif de réglage de filtre (1002) selon la revendication 1,
dans lequel le récepteur (1001) est configuré pour allumer le commutateur (1005) quand l'appareil cible (1006) est dans l'état de veille et le récepteur (1001) reçoit un signal pour changer l'appareil cible (1006) de l'état de veille à l'état fonctionnel.

12. Procédé de réglage pour un filtre ayant une caractéristique de filtre pouvant être commandée par un signal de commande de caractéristique, le procédé étant **caractérisé en ce qu'**il comprend :
de régler différentes caractéristiques de filtre pour le filtre par le signal de commande de caractéristique dans lequel un signal de référence a différentes amplitudes ;
de détecter des amplitudes d'un signal de sortie du filtre en se référant au signal de référence ayant les différentes amplitudes dans chacune des caractéristiques de filtre ; et
de déterminer un signal de commande de caractéristique souhaitée pour régler une caractéristique de filtre souhaitée selon les amplitudes détectées.

13. Procédé selon la revendication 12, **caractérisé en ce qu'**il comprend en outre :
d'entrer sélectivement l'un d'un signal d'entrée extérieur et du signal de référence vers le filtre.

14. Procédé selon la revendication 12, **caractérisé en ce que**
les amplitudes sont détectées en utilisant un convertisseur configuré pour convertir un signal analogique en un signal numérique.

15. Procédé selon la revendication 12, **caractérisé en ce que**
le signal de référence comprend un signal d'onde rectangulaire.

16. Procédé selon la revendication 12, **caractérisé en ce que**
le filtre comprend un filtre passe-bande,
le signal de référence comprend un signal ayant une fréquence d'une bande passante du filtre passe-bande, et
un signal de commande de caractéristique pour régler une caractéristique de filtre est déterminé comme le signal de commande de caractéristique souhaitée pour lequel une amplitude maximum d'un signal de sortie du filtre est détecté.

17. Procédé selon la revendication 12, **caractérisé en ce qu'**il comprend en outre :
de générer un premier signal de commande de caractéristique pour régler une caractéristique de premier filtre ;
de générer successivement un signal de commande d'amplitude pour changer successivement une amplitude du signal de référence en maintenant la caractéristique de filtre ; et
de générer un second signal de commande de caractéristique pour régler une caractéristique de second filtre quand l'amplitude du signal de référence varie aux amplitudes différentes.

18. Procédé selon la revendication 12, **caractérisé en ce qu'**il comprend en outre :
de générer un premier signal de commande d'amplitude pour régler une amplitude du signal de référence à une première amplitude ;
de générer successivement un signal de commande de caractéristique pour changer successivement une caractéristique de filtre dans un état où l'amplitude est maintenue ; et
de générer un second signal de commande d'amplitude pour régler une amplitude du signal de référence à une seconde amplitude quand le signal de caractéristique de filtre est dans un état où l'amplitude est maintenue.

19. Procédé selon la revendication 12, **caractérisé en ce qu'**il comprend en outre :
de régler grossièrement au moins une d'une caractéristique de premier filtre et d'une première amplitude ;
de déterminer une plage de signal de commande de caractéristique incluant le signal de commande de caractéristique souhaitée ;
de régler finement une seconde caractéristique de filtre dans la plage de signal de commande de caractéristique ; et
de régler finement une seconde amplitude du signal de référence par le signal de commande d'amplitude.
